# EUROPEAN PATENT APPLICATION

(11) **EP 4 800 881 A2**
(43) Date of publication of application: **02.09.2026**
(21) Application number: 26156089.0
(22) Date of filing: 03.02.2026
(51) Int. Cl.: H02J 9/06, F15B 20/00, G06F 1/30, H02J 7/34

(54) **FIELD REPLACEABLE ELECTRONIC RETURN FOR ACTUATOR**

(30) Priority: 07.02.2025 US 202519048747
(71) Applicant: Schneider Electric Buildings Americas, Inc., Carrollton, TX 75006 (US)
(72) Inventor: DU, John, 75006 Carrollton (US); GEISSBERGER, Jay, 75006 Carrollton (US); CARBONELL, Enrique, 75006 Carrollton (US); SINGH, Rishupreet, 75006 Carrollton (US); LETARTE, Isabelle, 75006 Carrollton (US); DIZDAR, Sabahattin, 75006 Carrollton (US)
(74) Representative: Openshaw & Co.

(57) **Abstract**

Systems/methods for providing an electronic return module (100) for a valve and damper actuator that can be easily installed and replaced in the field includes a backup power source (104). The backup power source (104) ensures that the actuator has sufficient power to return a valve or damper to a predefined fail-safe position in case of a power supply interruption. The electronic return module may use supercapacitors as the backup power source (104) that can quickly release the electrical energy stored and require a relatively short recharge time. Circuitry and firmware are provided for monitoring the supercapacitors for indications of operational or performance degradation and issue an alert signal to a user or process monitoring system to indicate that repair or replacement is needed.

## Description

### TECHNICAL FIELD

The present disclosure relates to automated actuators and particularly to systems and methods for providing an electronic return module for an actuator that includes a backup power source for controlling the actuator and can be easily installed and replaced in the field.

### BACKGROUND

Automated actuators are used to control valves, dampers, and other controlled devices in many types of industrial and consumer applications where the use of manual actuators is not feasible. Examples of automated actuators include hydraulic actuators, pneumatic actuators, electric actuators, among others. These actuators typically come equipped with a built-in safety mechanism that automatically actuates the controlled devices into a fail-safe position in an emergency event or other critical situation, such as a power outage. The safety mechanism may actuate the controlled device into an open position ("fail open"), a closed position ("fail close"), or some intermediate position, depending on the particular application.

Traditionally, fail-safe mechanisms employed a mechanical spring return to actuate the controlled device in the event of an emergency. However, the spring return required the actuator to compress a mechanical spring and maintain the spring in a compressed state for long intervals, which put extra strain on the actuator power supply and also weakened the spring over time. Additionally, the spring tended to generate an undesirable audible noise when released, and was capable of returning the controlled device only to a single predefined device position. To return the device to a different position typically required replacing the actuator with another actuator that was specifically configured for the new device position. For those spring return actuators that can be installed in either side, it was required to unmount and reinstall the actuator onto the opposite side.

Accordingly, while several advances have been made in the field of valve and damper actuators, it will be appreciated that improvements are continually needed.

### SUMMARY

Embodiments of the present disclosure relate to a system and method of providing an electronic return module for an actuator used to control valves, dampers, and other controlled devices. The electronic return module can be easily installed and replaced in the field and includes a backup power source that is separate from utility power. The backup power source ensures that the actuator has sufficient power to return a controlled device to a predefined fail-safe position, or one of several predefined fail-safe positions, in case of a power supply interruption. In some embodiments, the electronic return module advantageously uses supercapacitors as the backup power source due to their ability to quickly release the electrical energy stored and also require a relatively short recharge time. In some embodiments, the electronic return module also includes circuitry for monitoring the health of the supercapacitors. Firmware or programming can be provided in the actuator to allow the supercapacitors to be monitored continuously or on a regular basis for indications of operational or performance degradation. Such monitoring can detect, for example, when the supercapacitors approach the end of their useful life and issue an alert signal to a user or process monitoring system to indicate that repair or replacement is needed. In some embodiments, the electronic return module may include an optional protective enclosure that protects the supercapacitors, monitoring circuitry, and other onboard electronics and components from inadvertent physical contact.

In general, in one aspect, embodiments of the present disclosure relate to a field replaceable electronic return module for an actuator. The module comprises, among other things, a circuit board, and a backup power source mounted on the circuit board, the backup power source configured to store energy for backup power thereon. The module further comprises at least one sense circuit coupled to the backup power source and configured to sense at least one electrical parameter of the backup power source. The at least one sense circuit is configured to provide the at least one electrical parameter to the actuator to monitor a health status of the backup power source, and the backup power source is configured to provide the backup power to the actuator upon occurrence of a power event to allow the actuator to move a controlled device from a current position to a preselected fail-safe position.

In general, in another aspect, embodiments of the present disclosure relate to a method of providing a field replaceable electronic return for an actuator. The method comprises, among other things, providing a circuit board, and mounting a backup power source on the circuit board, the backup power source configured to store backup power thereon. The method further comprises providing at least one sense circuit coupled to the backup power source, the at least one sense circuit configured to sense at least one electrical parameter of the backup power source. The at least one sense circuit is configured to provide the at least one electrical parameter to the actuator to monitor a health status of the backup power source, and the backup power source is configured to provide the backup power to the actuator upon occurrence of a power event to allow the actuator to move a controlled device from a current position to a preselected fail-safe position.

In general, in yet another aspect, embodiments of the present disclosure relate to an actuator for a controlled device. The actuator comprises a control board and a microcontroller mounted on the control board. The actuator further comprises a field replaceable electronic return module configured to be connected to the control board and having a backup power source therein, the backup power source configured to store backup power thereon. The field replaceable electronic return module is configured to provide the backup power to the actuator upon occurrence of a power event, and the microcontroller is configured to cause the actuator to move the controlled device from a current position to a preselected fail-safe position upon occurrence of the power event using the backup power.

In accordance with any one or more of the foregoing embodiments, the at least one electrical parameter includes a voltage level and the actuator is configured to detect whether a health status of the backup power source is below a predefined health threshold based on the voltage level, and wherein the actuator is further configured to issue an alert signal to a user device or a monitoring system in response to detecting that the health status of the backup power source is below the predefined health threshold.

In accordance with any one or more of the foregoing embodiments, the predefined health threshold is a threshold that indicates the backup power source is nearing an end-of-life state. In accordance with any one or more of the foregoing embodiments, the preselected fail-safe position was preselected from among a plurality of fail-safe positions. In accordance with any one or more of the foregoing embodiments.

In accordance with any one or more of the foregoing embodiments, the backup power source includes one or more supercapacitors. In accordance with any one or more of the foregoing embodiments, the module has a compact size and shape configured to allow the module to be inserted into a module compartment in the actuator. In accordance with any one or more of the foregoing embodiments, a protective enclosure fits over the circuit board to protect the backup power supply.

### BRIEF DESCRIPTION OF THE DRAWINGS

FIG. 1 shows a schematic diagram of an exemplary electronic return module for an actuator according to embodiments of the present disclosure;
FIG. 2 shows a schematic diagram of an exemplary actuator and exemplary electronic return module therefor according to embodiments of the present disclosure;
FIG. 3 shows a block diagram for an exemplary flow control system according to embodiments of the present disclosure;
FIG. 4 shows a circuit diagram for an exemplary current sensing circuit for an electronic return module according to embodiments of the present disclosure;
FIG. 5 shows a circuit diagram for an exemplary discharge circuit for an electronic return module according to embodiments for the present disclosure;
FIG. 6 shows a circuit diagram for an exemplary voltage sensing circuit for an electronic return module according to embodiments of the present disclosure;
FIG. 7 shows a flowchart for an exemplary method that may be used with an electronic return module according to embodiments of the present disclosure;
FIG. 8 shows a block diagram for an exemplary processing system that may be used for an actuator according to embodiments of the disclosure; and
FIG. 9 shows a block diagram for an exemplary storage system that may be used for an actuator according to embodiments of the present disclosure.

### DETAILED DESCRIPTION

This description and the accompanying drawings illustrate exemplary embodiments of the present disclosure and should not be taken as limiting, with the claims defining the scope of the present disclosure, including equivalents. Various mechanical, compositional, structural, electrical, and operational changes may be made without departing from the scope of this description and the claims, including equivalents. In some instances, well-known structures and techniques have not been shown or described in detail so as not to obscure the disclosure. Further, elements and their associated aspects that are described in detail with reference to one embodiment may, whenever practical, be included in other embodiments in which they are not specifically shown or described. For example, if an element is described in detail with reference to one embodiment and is not described with reference to a second embodiment, the element may nevertheless be claimed as included in the second embodiment.

As alluded to above, embodiments of the present disclosure relate to a field replaceable electronic return module for an actuator of the type commonly used to actuate valves, dampers, and other controlled devices, and a method therefor. The electronic return module ensures that the actuator has sufficient power to position or reposition the controlled device upon occurrence of a power event by detecting the power event, activating a capacitor-based energy storage unit, and initiating a discharge of the capacitor-based energy storage unit to the actuator. As well, the electronic return module can be continuously monitored to obtain a health status of the capacitor-based energy storage unit, or current or voltage information that can be used to calculate the health status, which can then be provided to a user or a local or remote monitoring system. An alert signal, which may for example include an audio and/or visual alert, may be provided or sent to the user or a local or remote monitoring system if the health status of the capacitor-based energy storage unit falls below a predetermined health threshold. In some embodiments, the health threshold may be represented by a voltage level decrease, or the like, that indicates the capacitor-based energy storage unit is nearing an end-of-life state.

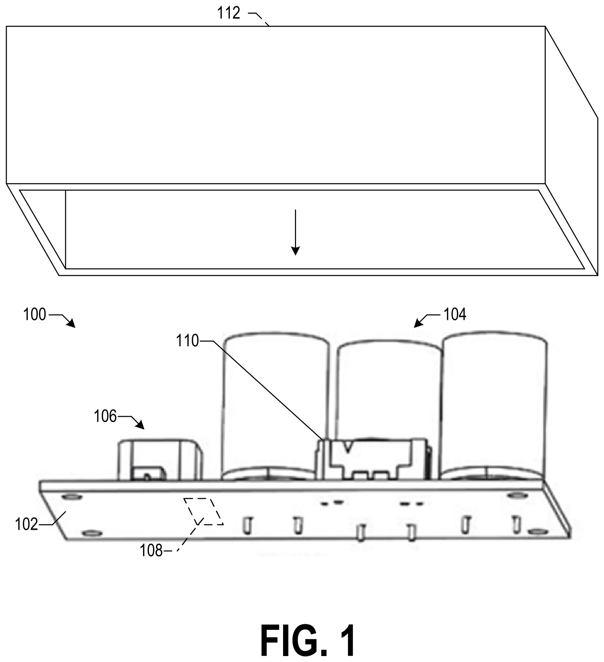

Referring now to FIG. 1, an exemplary electronic return module 100 for an actuator is shown according to embodiments of the present disclosure. The electronic return module 100 depicted here is beneficially designed to be field replaceable, meaning the module may be quickly and easily installed and replaced in the field without requiring any specialized tools or equipment. To this end, the electronic return module 100 preferably has a compact form factor that minimizes size and weight and maximizes portability. The field replaceable aspect of the module 100 is particularly useful for actuators that ship with a "fail-in-place" configuration, without a pre-installed electronic return. For such actuators, the electronic return module 100 can be quickly and easily added and any needed software upgrade installed after the actuators are already deployed to provide the actuators with an electronic return.

As FIG. 1 illustrates, the electronic return module 100 is composed of a circuit board 102 having one or more supercapacitors mounted on a surface thereof that provide a backup power source 104 for the electronic return module 100. Circuitry and other components, generally indicated at 106, may also be mounted on the circuit board 102, including both integrated circuits and discrete components alike (e.g., resistors, capacitors, diodes, switches, relays, etc.), depending on the requirements of the particular implementation. Although not visible here, various conductive traces are etched on or otherwise formed in the circuit board 102 to electrically connect the supercapacitors and the other components 106 to one another. Optionally, in some embodiments, a module controller 108 (dashed lines) or other programmable logic may be mounted on the circuit board 102 to provide or perform any functions that may be needed by the electronic return module 100, whether in addition to or in conjunction with the circuitry and other components 106. As well, it will be appreciated that other types of power sources besides supercapacitors may be used for the backup power source 104, including chemical-based (e.g., batteries, etc.) and other non-capacitor-based power sources. A receptacle connector 110 allows the electronic return module 100 to be electrically connected to and communicate with an actuator when the module 100 is inserted in the actuator. The receptacle connector 110 in this embodiment is designed to receive an insertion type board connector.

In some embodiments, the electronic return module 100 also comes with an optional protective enclosure 112 that fits snugly over the circuit board 102 to protect the various components mounted thereon from being damaged during shipping and handling. Such a protective enclosure 112 may be made of any suitable protective material (e.g., metal, plastic, etc.), and may be secured to the circuit board 102 using any suitable securing means (e.g., screws, clamps, snap-on, etc.). In some embodiments, the protective enclosure 112 also serves as ingress protection where a waterproof seal is required for compliance with NEMA II or IP54 of the Ingress Protection code, as defined by the International Electrotechnical Commission (IEC), and other applicable safety standards.

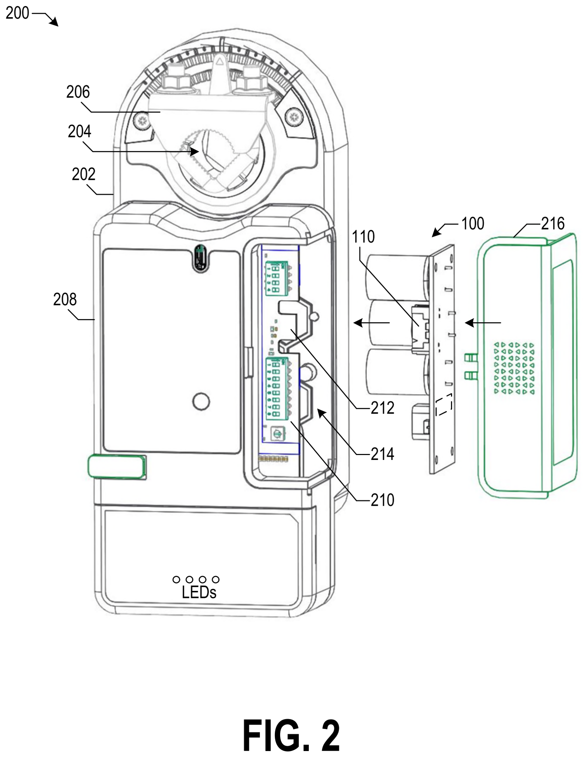

FIG. 2 illustrates an exemplary actuator 200 that can receive the exemplary electronic return module 100 therein, either as a new installation or a modular replacement, according to embodiments of the present disclosure. The actuator 200 depicted here resembles a typical rotary type actuator for a damper application insofar as there is a main housing 202 encasing an actuator motor therein (not shown), and a generally circular output shaft 204 provided near the top of the main housing 202 for direct coupling to a damper input shaft (not shown). A clamping assembly 206 is mounted to the housing 202 over the output shaft 204 for securely clamping the actuator 200 around the damper input shaft. A control housing 208 is attached to the main housing 202 and encloses various control electronics therein for controlling the actuator 200.

The control electronics in this embodiment include a control board 210 having a microcontroller or other programmable control logic and components mounted thereon, conductive traces formed therein (not expressly shown) that electrically connect the components to one another, and an insertion type board connector 212. The board connector 212 is designed to be inserted into the receptacle connector 110 of the circuit board 102 to allow the actuator 200 to be electrically connected to and communicate with the electronic return module 100. To this end, the control housing 208 of the valve actuator 200 comes with a generally rectangular slot or compartment 214 having a size and shape designed to receive the electronic return module 100 therein.

A cover 216 may then be snapped on or otherwise attached to the control housing 208 over the module compartment 214 to protect the circuit boards and other components therein. The cover 216 may also be hingedly attached to the control housing 208 in some embodiments so as to swing open and closed over the compartment 214 as needed.

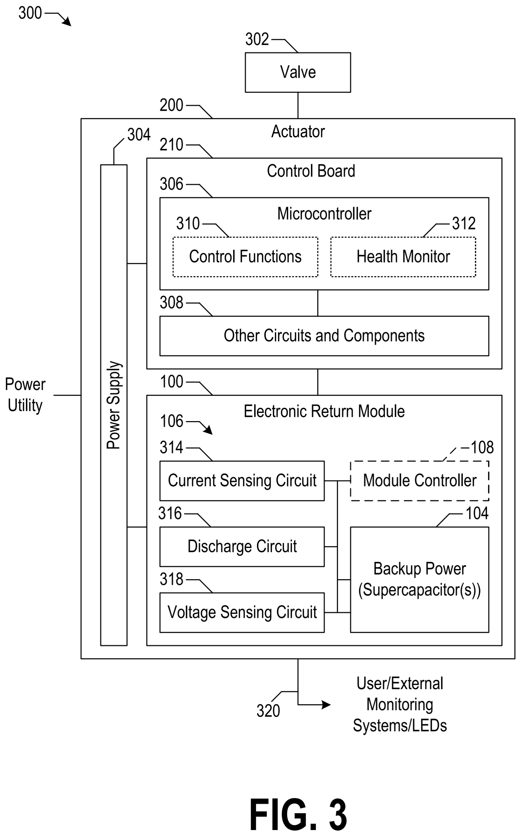

FIG. 3 illustrates an exemplary flow control system 300 having the exemplary actuator 200 with the electronic return module 100 installed therein along with the control board 210 mentioned earlier, in simplified block diagram form. The flow control system 300 here resembles a typical flow control system for an industrial or residential application insofar as there is a valve 302 or similar controlled device that can be opened or closed by the actuator 200 to control the flow of liquid or gas through the valve 302, typically in real time. Power for the actuator 200 comes from a power supply 304, typically via a power utility, and is monitored by the actuator 200 on a continuous basis for occurrence of a power loss or other power event.

In the present example, the control board 210 has a microcontroller 306 or similar programmable logic and other circuits and components 308 mounted thereon for operation of the actuator 200. As can be seen, the microcontroller 306 is configured or otherwise programmed with various control functions 310 for controlling operation of the actuator 200. These control functions 310 may include monitoring the power supply 304 for occurrence of a power outage or other interruption in a known manner via one or more of the circuits and components 308. Upon detecting such an outage, the microcontroller 306 is configured to send or issue a control signal to cause the actuator 200 to articulate the valve 302 to a preset fail-safe valve position. The microcontroller 306 is also configured or otherwise programmed with a health monitor function 312 that monitors a health status of the supercapacitors in the backup power source 104 and, in some embodiments, communicates that health status, or information that can be used to determine such health status, to a user and/or external monitoring system.

When a power event occurs, the microcontroller 306 on the control board 210 is configured to control or otherwise cause the electronic return module 100 to power the actuator 200 using electrical energy stored in the backup power source 104. This ensures that there will be sufficient power in the actuator 200 to articulate the valve 302 into a fail-safe valve position during the power event. Where the actuator 200 is a type that is capable of articulating the valve 302 into two or more different fail-safe valve positions, the electrical energy provided by the electronic return module 100 allows the actuator 200 to articulate the valve 302 into a preselected one of the multiple fail-safe positions. The microcontroller 306 is also configured to monitor the electronic return module 100 on a continuous basis to determine and communicate the health status of the backup power source 104 to a user or external monitoring system (e.g., a local or remote monitoring system).

To monitor the electronic return module 100, a current sensing circuit 314, a supercapacitor discharge circuit 316, and a voltage sensing circuit 318 may be provided therein and connected as shown. The current sensing circuit 314 is configured to sense or otherwise obtain a current level from the supercapacitors in the backup power source 104 and provide or otherwise make this current level available to the microcontroller 306 (e.g., via the receptacle connector 110) to use in monitoring the electronic return module 100. The supercapacitor discharge circuit 316, upon being controlled or otherwise engaged by the microcontroller 306, is configured to discharge the supercapacitors in the backup power source 104 for purposes of testing the charging/discharging ability of the supercapacitors. Meanwhile, the voltage sensing circuit 318 is configured to sense or otherwise obtain a voltage level of the supercapacitors and provide or otherwise make this voltage level available to the microcontroller 306 (e.g., via the receptacle connector 110) to use in monitoring the electronic return module 100.

The microcontroller 306 can then check a health status of the supercapacitors in the backup power source 104 by monitoring the current and/or voltage levels from the current and voltage sensing circuits 314 and 318. This may involve the microcontroller 306 determining, based on the current and/or voltage levels, a current charge state of the supercapacitors (e.g., high, medium, low, etc.), whether the charge state has increased or decreased relative to a previous health check, and so forth. Any suitable technique known to those skilled in the art may be used to check the health status of the supercapacitors within the scope of the present disclosure. In some embodiments, the microcontroller 306 also communicates the health status, or at least information that may be used to determine the health status, to a user or a mobile device thereof, a local, and/or a remote monitoring system via an appropriate wired or wireless communication link 320.

The microcontroller 306 also issues an alert signal to the user or the external monitoring system (e.g., local or remote monitoring system) if the health status, as determined by the microcontroller 306, falls below a predefined health threshold. For example, the health threshold may be a given size of voltage level decrease occurring within a given amount of time that is known to be an indication that the supercapacitors are nearing an end-of-life state, depending on the supercapacitor type. The alert signal may include an audio and/or visual alert in some embodiments, such as a beeping sound, an LED indicator, and the like.

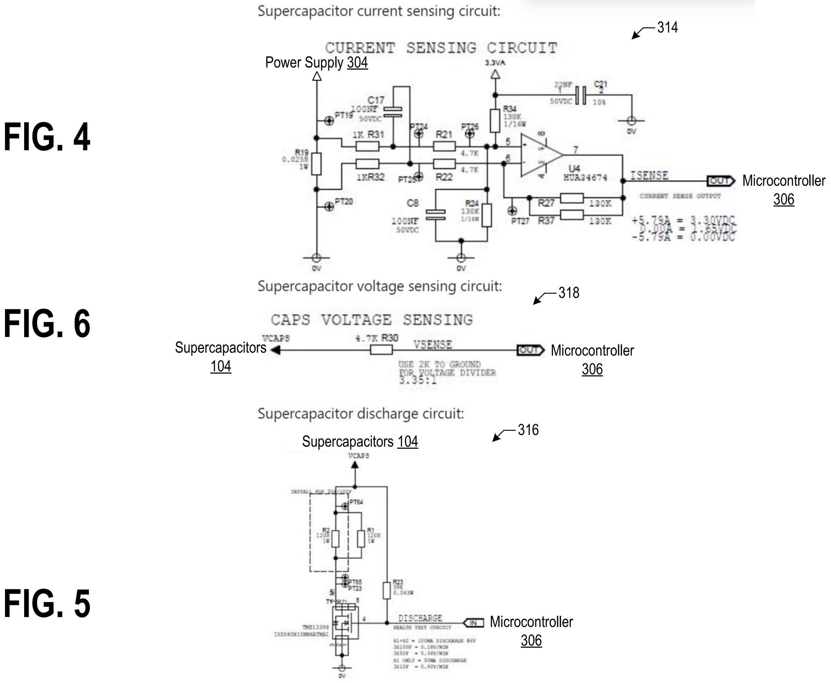

FIG. 4 illustrates an exemplary implementation of a current sensing circuit in circuit diagram form that may be used as the current sensing circuit 314 shown in FIG. 3. FIG. 5 illustrates an exemplary implementation of a supercapacitor discharge circuit in circuit diagram form that may be used as the super capacitor discharge circuit 316 shown in FIG. 3. Although not depicted here, a circuit similar to the one in FIG. 5 may be used to control charging/recharging of the supercapacitors once the power supply 304 is restored. FIG. 6 illustrates an exemplary implementation of a voltage sensing circuit in circuit diagram form that may be used as the voltage sensing circuit 318 shown in FIG. 3. It will be appreciated that the exemplary circuits 314, 316, and 318 in these figures are illustrative only, and variations and modifications of the circuits are within the ability of one having ordinary skill in the art. For example, although separate sense circuits 314 and 318 are described, the electrical parameters sensed by these circuits may also be obtained using a single integrated circuit that combines the capabilities both sense circuits.

In addition, although various functions and operations disclosed herein have been described as being performed by the microcontroller 306 of the control board 210, embodiments of the present disclosure are not limited to this arrangement. In embodiments where the optional module controller 108 is present in the electronic return module 100, one or more of the functions and operations described above as being performed by the microcontroller 306 in the control board 210 may instead be performed by the module controller 108 in the electronic return module 100. For example, detecting occurrence of a power event may be performed by the module controller 108 in the electronic return module 100, or monitoring a health status of the backup power source 104 may be performed by the module controller 108 in the electronic return module 100.

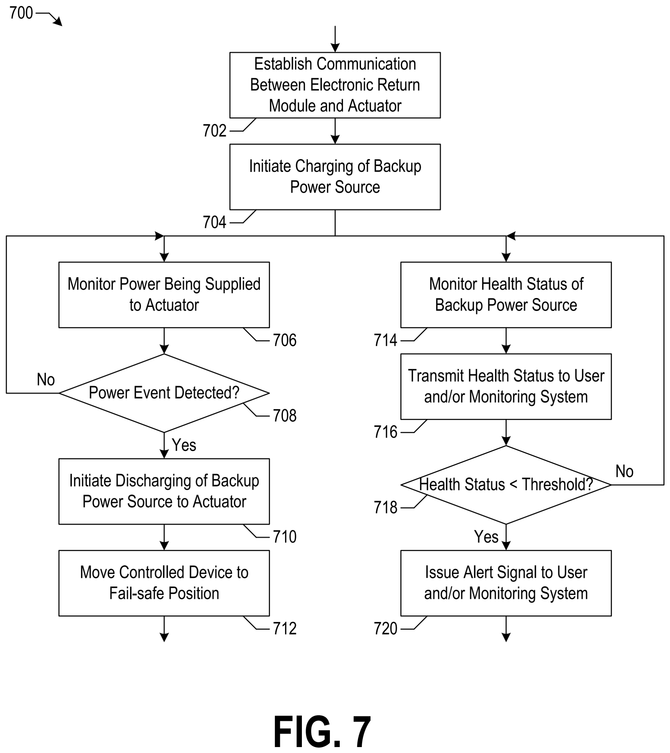

Referring now to FIG. 7, a flowchart 700 is shown representing a method that may be used with the electronic return module 100 and the actuator 200, and particularly the microcontroller 306 therein, according to embodiments of the present disclosure. The method generally begins after the electronic return module 100 is inserted into the actuator 200. At block 702, the actuator 200 establishes communication with the module 100 using an appropriate communication protocol. Examples of suitable communication protocols include Serial Peripheral Interface (SPI), Inter-Integrated Circuit (I2C), Universal Asynchronous Receiver/Transmitter (UART), among others. At block 704, the actuator 200 initiates charging of the backup power source 104, which may include the one or more supercapacitors discussed above in some embodiments. Such charging may be accomplished using a charge circuit similar to the supercapacitor discharge circuit 316 in some embodiments, as discussed above. At block 706, power being supplied to the actuator 200 is monitored for occurrence of a power outage or other power event in a known manner.

At block 708, a determination is made whether a power event has been detected based on the monitoring in block 706. If the determination is no, then the actuator 200 returns to block 706 and continues to monitor the power being supplied. If the determination is yes, then at block 710, the backup power source 104 is engaged or activated to begin providing backup power to the actuator 200. Thereafter, the backup power provided by the backup power source 104 is used by the actuator 200 to articulate the valve 302 or other controlled device into a fail-safe position, at block 712. The actuator 200 may thereafter proceed to carry out any further functions as may be appropriate for the application.

Concurrently with the above, at block 714, the actuator 200 also monitors a health status of the backup power source 104, for example, by obtaining current and/or voltage level measurements for the one or more supercapacitors. In some embodiments, the current and/or voltage level measurements may be accomplished using the current sensing circuit 314 and/or the voltage sensing circuit 318, or similar circuits, as described above. A discharge circuit 316 or similar circuit may also be used to test the discharging/charging ability of the one or more super capacitors as part of the health monitoring. At block 716, the actuator 200 transmits or otherwise communicates the health status to a user or a mobile device of the user, a local monitoring system, and/or a remote monitoring system via an appropriate wired or wireless link 320. The transmission may occur each time a health status is obtained for the backup power source, or it may occur on a regular basis, for example, once every hour, two hours, three hours, and so forth.

At block 718, the actuator 200 makes a determination whether the health status of the backup power source 104 has degraded below a certain health threshold. In some embodiments, this determination may be accomplished by comparing the voltage measurement from the supercapacitors to a predefined threshold voltage level, which threshold voltage level may indicate that the supercapacitors are nearing an end-of-life state. Other techniques known to those having ordinary skill in the art may also be used for analyzing a health status of the backup power source, for example, as described in commonly-assigned US2023/0194631A1, which is incorporated herein by reference in its entirety. If the determination is no, then the actuator 200 returns to block 714 to continue monitoring the health status of the backup power source 104. If the determination is yes, then the actuator 200 at block 720 issues an alert signal to the user or a mobile device of the user, a local, and/or a remote monitoring system. The user may then repair or replace the supercapacitors in the backup power source 104 or take any other user action that may be needed. Likewise, the local or remote monitoring system may also take any predefined system action that may be needed. The actuator 200 may thereafter continue with any additional steps as may be appropriate for the application.

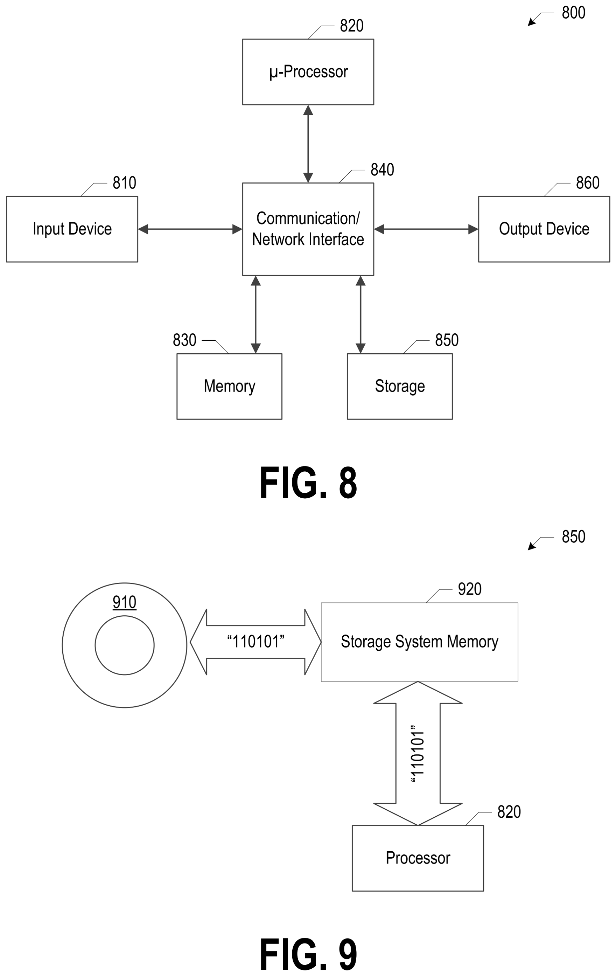

FIG. 8 shows an exemplary system that may be used to implement various embodiments of the actuator and the electronic return module, and particularly the microcontroller or controller therein, as discussed in this disclosure. For example, various embodiments of the disclosure may be implemented using specialized software executing in a computing system 800 such as that shown in FIG. 8. The system 800 may include a microprocessor or "processor" 820 connected to one or more memory devices 830, such as magnetic or solid state memory, either embedded and discrete, or other memory devices for storing data. Memory 830 is typically used for storing programs and data during operation of the system 800. The system 800 may also include a storage system 850 that provides additional storage capacity. Components of system 800 may be coupled by a communication interface 840, which may include one or more buses (e.g., between components that are integrated within the same machine) and/or a network interface 840 (e.g., between components that reside on separate discrete machines). The communication/network interface 840 enables communications (e.g., data, instructions) to be exchanged between system components of system 800 and system components of other systems on the network.

System 800 also includes one or more input devices 810, for example, keys, buttons, microphone, touch screen, and one or more output devices 860, for example, a display screen, LEDs, and the like. In addition, system 800 may contain one or more interfaces (not shown) that connect system 800 to a communication network (in addition or as an alternative to the interconnection mechanism 840).

The storage system 850, shown in greater detail in FIG. 9, typically includes a computer readable and writeable nonvolatile recording medium 910 in which signals are stored that define a program to be executed by the processor 820 or information stored on or in the medium 910 to be processed by the program to perform one or more functions associated with embodiments described herein. To this end, the processor 820 may be any suitable processing unit, such as a microprocessor, ASIC, and the like, and the medium any suitable recording medium, such as a magnetic or solid-state memory. Typically, in operation, the processor 820 causes data to be read from the nonvolatile recording medium 910 into storage system memory 920 that allows for faster access to the information by the processor than does the medium 910. This storage system memory 920 is typically a volatile, random access memory such as a dynamic random-access memory (DRAM) or static memory (SRAM). This storage system memory 920 may be located in storage system 850, as shown, or in the system memory 830. The processor 820 generally manipulates the data within the memory system 920 and then copies the data to the medium 910 after processing is completed. A variety of mechanisms are known for managing data movement between the medium 910 and the integrated circuit memory element 920, and the disclosure is not limited thereto. The disclosure is not limited to a particular memory 920, memory 830 or storage system 850.

The system 800 may include specially programmed, special-purpose hardware, for example, an application-specific integrated circuit (ASIC). Aspects of the disclosure may be implemented in software, hardware or firmware, or any combination thereof. Further, such methods, acts, systems, system elements and components thereof may be implemented as part of the system described above or as an independent component.

Although the system 800 is shown by way of example as one type of system upon which various aspects of the disclosure may be practiced, it should be appreciated that aspects of the disclosure are not limited to being implemented on the system as shown in FIG. 8. Various aspects of the disclosure may be practiced on one or more devices having a different architecture or components from that shown in FIG. 8. Further, where functions or processes of embodiments of the disclosure are described herein (or in the claims) as being performed on a processor or controller, such description is intended to include systems that use more than one processor or controller to perform the functions.

In the preceding, reference is made to various embodiments. However, the scope of the present disclosure is not limited to the specific described embodiments. Instead, any combination of the described features and elements, whether related to different embodiments or not, is contemplated to implement and practice contemplated embodiments. Furthermore, although embodiments may achieve advantages over other possible solutions or over the prior art, whether or not a particular advantage is achieved by a given embodiment is not limiting of the scope of the present disclosure. Thus, the preceding aspects, features, embodiments and advantages are merely illustrative and are not considered elements or limitations of the appended claims except where explicitly recited in a claim(s).

It will be appreciated that the development of an actual commercial application incorporating aspects of the disclosed embodiments will require many implementation-specific decisions to achieve a commercial embodiment. Such implementation specific decisions may include, and likely are not limited to, compliance with system related, business related, government related and other constraints, which may vary by specific implementation, location and from time to time. While a developer's efforts might be considered complex and time consuming, such efforts would nevertheless be a routine undertaking for those of skill in this art having the benefit of this disclosure.

It should also be understood that the embodiments disclosed and taught herein are susceptible to numerous and various modifications and alternative forms. Thus, the use of a singular term, such as, but not limited to, "a" and the like, is not intended as limiting of the number of items. Similarly, any relational terms, such as, but not limited to, "top," "bottom," "left," "right," "upper," "lower," "down," "up," "side," and the like, used in the written description are for clarity in specific reference to the drawings and are not intended to limit the scope of the invention.

This disclosure is not limited in its application to the details of construction and the arrangement of components set forth in the following descriptions or illustrated by the drawings. The disclosure is capable of other embodiments and of being practiced or of being carried out in various ways. Also, the phraseology and terminology used herein is for the purpose of descriptions and should not be regarded as limiting. The use of "including," "comprising," "having," "containing," "involving," and variations herein, are meant to be open-ended, i.e., "including but not limited to".

The various embodiments disclosed herein may be implemented as a system, method or computer program product. Accordingly, aspects may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects may take the form of a computer program product embodied in one or more computer-readable medium(s) having computer-readable program code embodied thereon.

Any combination of one or more computer-readable medium(s) may be utilized. The computer-readable medium may be a non-transitory computer-readable medium. A non-transitory computer-readable medium may be, for example, but not limited to, an electronic, magnetic, optical, electromagnetic, infrared, or semiconductor system, apparatus, or system, or any suitable combination of the foregoing. More specific examples (a non-exhaustive list) of the non-transitory computer-readable medium can include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage system, a magnetic storage system, or any suitable combination of the foregoing. Program code embodied on a computer-readable medium may be transmitted using any appropriate medium, including but not limited to wireless, wireline, optical fiber cable, RF, etc., or any suitable combination of the foregoing.

Computer program code for carrying out operations for aspects of the present disclosure may be written in any combination of one or more programming languages. Moreover, such computer program code can execute using a single computer system or by multiple computer systems communicating with one another (e.g., using a local area network (LAN), wide area network (WAN), the Internet, etc.). While various features in the preceding are described with reference to flowchart illustrations and/or block diagrams, a person of ordinary skill in the art will understand that each block of the flowchart illustrations and/or block diagrams, as well as combinations of blocks in the flowchart illustrations and/or block diagrams, can be implemented by computer logic (e.g., computer program instructions, hardware logic, a combination of the two, etc.). Generally, computer program instructions may be provided to a processor(s) of a general-purpose computer, special-purpose computer, or other programmable data processing apparatus. Moreover, the execution of such computer program instructions using the processor(s) produces a machine that can carry out a function(s) or act(s) specified in the flowchart and/or block diagram block or blocks.

One or more portions of the computer system may be distributed across one or more computer systems coupled to a communications network. For example, as discussed above, a computer system that determines available power capacity may be located remotely from a system manager. These computer systems also may be general-purpose computer systems. For example, various aspects of the disclosure may be distributed among one or more computer systems configured to provide a service (e.g., servers) to one or more client computers, or to perform an overall task as part of a distributed system. For example, various aspects of the disclosure may be performed on a client-server or multi-tier system that includes components distributed among one or more server systems that perform various functions according to various embodiments of the disclosure. These components may be executable, intermediate (e.g., IL) or interpreted (e.g., Java) code which communicate over a communication network (e.g., the Internet) using a communication protocol (e.g., TCP/IP). For example, one or more database servers may be used to store system data, such as expected power draw, that is used in designing layouts associated with embodiments of the present disclosure.

Various embodiments of the present disclosure may be programmed using an object-oriented programming language, such as SmallTalk, Java, C++, Ada, or C# (C-Sharp). Other object-oriented programming languages may also be used. Alternatively, functional, scripting, and/or logical programming languages may be used, such as BASIC, Fortran, Cobol, TCL, Lua, Python, Rust or basic C. Various aspects of the disclosure may be implemented in a non-programmed environment (e.g., analytics platforms, or documents created in HTML, XML or other format that, when viewed in a window of a browser program render aspects of a graphical-user interface (GUI) or perform other functions). Various aspects of the disclosure may be implemented as programmed or non-programmed elements, or any combination thereof.

The flowchart and block diagrams in the Figures illustrate the architecture, functionality and/or operation of possible implementations of various embodiments of the present disclosure. In this regard, each block in the flowchart or block diagrams may represent a module, segment or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

Thus far, a number of features and advantages of embodiments of the present disclosure have been shown and described. Other possible features and advantages associated with the disclosed embodiments will be appreciated by one of ordinary skill in the art. It should also be understood that embodiments of the disclosure herein may be configured as a system, method, or combination thereof. Accordingly, embodiments of the present disclosure may be comprised of various means including hardware, software, firmware or any combination thereof.

While particular embodiments and applications of the present disclosure have been illustrated and described, it is to be understood that embodiments of the disclosure not limited to the precise construction and compositions disclosed herein and that various modifications, changes, and variations can be apparent from the foregoing descriptions without departing from the scope of the disclosure as defined in the appended claims.

Further aspects of the invention are provided by the subject matter of the following clauses:
Clause 1. A field replaceable electronic return module for an actuator, the module comprising: a circuit board; a backup power source mounted on the circuit board, the backup power source configured to store backup power thereon; at least one sense circuit coupled to the backup power source and configured to sense at least one electrical parameter of the backup power source; wherein the at least one sense circuit is configured to provide the at least one electrical parameter to the actuator to monitor a health status of the backup power source; and wherein the backup power source is configured to provide the backup power to the actuator upon occurrence of a power event to allow the actuator to move a controlled device from a current position to a preselected fail-safe position.
Clause 2. The field replaceable electronic return module of Clause 1, wherein the at least one electrical parameter includes a voltage level and wherein the actuator is configured to detect whether a health status of the backup power source is below a predefined health threshold based on the voltage level; and wherein the actuator is further configured to issue an alert signal to a user device or a monitoring system in response to detecting that the health status of the backup power source is below the predefined health threshold.
Clause 3. The field replaceable electronic return module of Clause 2, wherein the predefined health threshold is a threshold that indicates the backup power source is nearing an end-of-life state.
Clause 4. The field replaceable electronic return module of any of Clauses 1 to 3, wherein the preselected fail-safe position was preselected from among a plurality of fail-safe positions.
Clause 5. The field replaceable electronic return module of any of Clauses 1 to 4, wherein the backup power source includes one or more supercapacitors.
Clause 6. The field replaceable electronic return module of any of Clauses 1 to 5, wherein the module has a compact size and shape configured to allow the module to be inserted into a module compartment in the actuator.
Clause 7. The field replaceable electronic return module of any of Clauses 1 to 6, further comprising a protective enclosure configured to fit over the circuit board to protect the backup power source.
Clause 8. A method of providing a field replaceable electronic return for an actuator, the method comprising: providing a circuit board; mounting a backup power source on the circuit board, the backup power source configured to store backup power thereon; providing at least one sense circuit coupled to the backup power source, the at least one sense circuit configured to sense at least one electrical parameter of the backup power source; wherein the at least one sense circuit is configured to provide the at least one electrical parameter to the actuator to monitor a health status of the backup power source; and wherein the backup power source is configured to provide the backup power to the actuator upon occurrence of a power event to allow the actuator to move a controlled device from a current position to a preselected fail-safe position.
Clause 9. The method of Clause 8, wherein the at least one electrical parameter includes a voltage level and wherein the actuator is configured to detect whether a health status of the backup power source is below a predefined health threshold based on the voltage level; and wherein the actuator is further configured to issue an alert signal to a user device or a monitoring system in response to detecting that the health status of the backup power source is below the predefined health threshold.
Clause 10. The method of Clause 9, wherein the predefined health threshold is a threshold that indicates the backup power source is nearing an end-of-life state.
Clause 11. The method of any of Clauses 8 to 10, wherein the preselected fail-safe position was preselected from among a plurality of fail-safe positions.
Clause 12. The method of any of Clauses 8 to 11, wherein mounting the backup power source on the circuit board comprises mounting one or more supercapacitors on the circuit board.
Clause 13. The method of any of Clauses 8 to 12, further comprising providing the field replaceable electronic return with a compact size and shape configured to allow the field replaceable electronic return to be inserted into a module compartment in the actuator.
Clause 14. The method of any of Clauses 8 to 13, further comprising providing a protective enclosure for the field replaceable electronic return, the protective enclosure configured to fit over the circuit board to protect the backup power supply.
Clause 15. An actuator for a controlled device, comprising: a control board; a microcontroller mounted on the control board; and a field replaceable electronic return module configured to be connected to the control board and having a backup power source therein, the backup power source configured to store backup power thereon; wherein the field replaceable electronic return module is configured to provide the backup power to the actuator upon occurrence of a power event; and wherein the microcontroller is configured to cause the actuator to move the controlled device from a current position to a preselected fail-safe position upon occurrence of the power event using the backup power.
Clause 16. The actuator of Clause 15, wherein the field replaceable electronic return module is further configured to provide a voltage level of the backup power source to the microcontroller; and wherein the microcontroller is configured to detect whether a health status of the backup power source is below a predefined health threshold based on the voltage level, and issue an alert signal to a user device or a monitoring system in response to detecting that the health status of the backup power source is below the predefined health threshold.
Clause 17. The actuator of Clause 16, wherein the predefined threshold is a threshold that indicates the is nearing an end-of-life state.
Clause 18. The actuator of any of Clauses 15 to 17, wherein the preselected fail-safe position was preselected from among a plurality of fail-safe positions.
Clause 19. The actuator of any of Clauses 15 to 18, wherein the backup power source includes one or more supercapacitors.
Clause 20. The actuator of any of Clauses 15 to 19, wherein the field replaceable electronic return module has a compact size and shape configured to allow the module to be inserted into a module compartment in the actuator.

## Claims

1. A field replaceable electronic return module (100) for an actuator (200), the module (100) comprising:
a circuit board (102);
a backup power source (104) mounted on the circuit board (102), the backup power source (104) being configured to store energy for backup power thereon; and
at least one sense circuit (314, 318) coupled to the backup power source (104) and configured to sense at least one electrical parameter of the backup power source (104);
wherein the at least one sense circuit (314, 318) is configured to provide the at least one electrical parameter to the actuator (200) to monitor a health status of the backup power source (104); and
wherein the backup power source (104) is configured to provide the backup power to the actuator (200) upon occurrence of a power event to allow the actuator (200) to move a controlled device from a current position to a preselected fail-safe position.

2. The module (100) of claim 1, wherein the at least one electrical parameter includes a voltage level and wherein the actuator (200) is configured to detect whether a health status of the backup power source (104) is below a predefined health threshold based on the voltage level; and
wherein the actuator (200) is configured to issue an alert signal to at least one of a user device or a monitoring system in response to detecting that the health status of the backup power source (104) is below the predefined health threshold.

3. The module (100) of claim 2, wherein the predefined health threshold is a threshold that indicates the backup power source (104) is nearing an end-of-life state.

4. The module (100) of any of claims 1 to 3, wherein the preselected fail-safe position was preselected from among a plurality of fail-safe positions.

5. The module (100) of any of claims 1 to 4, wherein the backup power source (104) includes one or more supercapacitors.

6. The module (100) of any of claims 1 to 5, wherein the module (100) has a size and shape configured to allow the module (100) to be inserted into a module compartment in the actuator (200).

7. The module (100) of any of claims 1 to 6, comprising a protective enclosure configured to fit over the circuit board (102) to protect the backup power source (104).

8. A method of providing a field replaceable electronic return for an actuator (200), the method comprising:
providing a circuit board (102);
mounting a backup power source (104) on the circuit board (102), the backup power source (104) being configured to store energy for backup power thereon;
providing at least one sense circuit (314, 318) coupled to the backup power source (104), the at least one sense circuit (314, 318) being configured to sense at least one electrical parameter of the backup power source (104);
wherein the at least one sense circuit (314, 318) is configured to provide the at least one electrical parameter to the actuator (200) to monitor a health status of the backup power source (104); and
wherein the backup power source (104) is configured to provide the backup power to the actuator (200) upon occurrence of a power event to allow the actuator (200) to move a controlled device from a current position to a preselected fail-safe position.

9. The method of claim 8, wherein the at least one electrical parameter includes a voltage level and wherein the actuator (200) is configured to detect whether a health status of the backup power source (104) is below a predefined health threshold based on the voltage level; and
wherein the actuator (200) is configured to issue an alert signal to a user device or a monitoring system in response to detecting that the health status of the backup power source (104) is below the predefined health threshold.

10. An actuator (200) for a controlled device, the actuator (200) comprising:
a control board (210);
a microcontroller mounted on the control board (210); and
a field replaceable electronic return module (100) configured to be connected to the control board (210) and having a backup power source (104) therein, the backup power source (104) being configured to store energy for backup power thereon;
wherein the field replaceable electronic return module (100) is configured to provide the backup power to the actuator (200) upon occurrence of a power event; and
wherein the microcontroller is configured to cause the actuator (200) to move the controlled device from a current position to a preselected fail-safe position upon occurrence of the power event using the backup power.

11. The actuator (200) of claim 10, wherein the field replaceable electronic return module (100) is configured to provide a voltage level of the backup power source (104) to the microcontroller; and
wherein the microcontroller is configured to detect whether a health status of the backup power source (104) is below a predefined health threshold based on the voltage level, and issue an alert signal to a user device or a monitoring system in response to detecting that the health status of the backup power source (104) is below the predefined health threshold.

12. The actuator (200) of claim 11, wherein the predefined health threshold is a threshold that indicates the backup power source (104) is nearing an end-of-life state.

13. The actuator (200) of any of claims 10 to 12, wherein the preselected fail-safe position was preselected from among a plurality of fail-safe positions.

14. The actuator (200) of any of claims 10 to 13, wherein the backup power source (104) includes one or more supercapacitors.

15. The actuator (200) of any of claims 10 to 14, wherein the field replaceable electronic return module (100) has a size and shape configured to allow the module (100) to be inserted into a module compartment in the actuator (200).
